# EUROPEAN PATENT SPECIFICATION

(11) **EP 1 202 448 B1**
(45) Date of publication and mention of the grant of the patent: **08.02.2006**
(21) Application number: 00309322.6
(22) Date of filing: 23.10.2000
(51) Int. Cl.: H03G 3/00, H03G 3/30

(54) **Method and device for adapting transmission power levels in transmission systems**
Verfahren und Vorrichtung zum Anpassen von Sendepegeln in Übertragungssystemen
Méthode et dispositif d'adaptation de niveaux de transmission dans des systèmes de transmission

(43) Date of publication of application: 02.05.2002
(73) Proprietor: LUCENT TECHNOLOGIES INC., Murray Hill, New Jersey 07974-0636 (US)
(72) Inventor: Fischer, Georg, 90419 Nurnberg (DE)
(74) Representative: Sarup, David Alexander

(56) References cited:
- EP-A- 1 011 207
- US-A- 5 708 681

## Description

The invention relates to a method and a device for adapting the transmission power level in transmission systems, in particular in mobile radio systems, in which a digitally processed transmission signal is converted for transmission into an analog signal and is fed to a transmission stage.

In essentially all currently used transmission systems, but also in transmission systems which may only be developed in the future, emphasis is placed in terms of signal or information transmission on the adaptation or control and/or regulation of largely optimum levels of the transmission power.

An objective of this optimization, depending on the type of transmission path and/or the distance to be covered, is normally to guarantee that the individual transmission signals are received at the receiving end with essentially equal strength. As is known per se to the person skilled in the art, particularly the use of available capacities can thereby be improved, since the signals to be transmitted need to be radiated by the relevant transmitters with only the minimum required energy. Furthermore, possible interference to other connections can be reduced, which in turn can have a positive effect on the available capacity and the quality of the individual connections. In addition, due to power level control at the transmitting end, existing path loss can be taken at least partly into consideration in advance and thereby correspondingly compensated.

Continuous power adaptation of transmission signals is required in particular in transmission systems which use multiple access based on time-slot structures, for example the TDMA (Time Division Multiple Access) method in mobile radio systems.

Since the individual time slots are in each case allocated to different network components and, within one time slot, only the transmission signals intended in each case for a predefined receiver are transmitted, a predefined power level is required in each case for the transmission of each data burst, i.e. the transmission signals within one time slot, in addition to high-precision synchronization between the transmitter and receiver.

In order to guarantee that successive data bursts, which are normally transmitted via different path routes in each case with their own path losses, are received at the corresponding receiving end with an essentially equal signal power, all changeover processes in terms of the transmission signal characteristics required for the following data burst, for example the required power stages, power levels and/or power frequencies, are therefore carried out within defined "guard periods" between individual adjacent data bursts. On the basis of the transmission power level adapted for the preceding data burst, the transmission power is initially essentially fully keyed down for this purpose and is keyed up once more to a correspondingly re-adapted power level only at the end of all necessary changeover processes at the start of the following data burst. The keying itself is carried out in a conventional "soft" manner, i.e. the power is evenly run up and down.

The essentially complete rundown of the transmitter within a guard period is mandatory to the extent that, as a result of the changeover processes to be carried out, no interference is caused. In a mobile radio system according to the GSM standard using the TDMA method, for example, around 28 µs are available in each case in an ongoing connection for transmission power adaptation.

Not only in the use of a TDMA method of this type, but also increasingly in other transmission systems, the signals to be transmitted are initially digitally processed and then, following conversion into an analog signal, are fed via a power amplifier to an actuator, for example as in mobile radio systems, to a transmission antenna.

A D/A converter activated for the 10-bit digital-to-analog conversion can therefore, since each bit produces an improvement of 6 dB, cover a power range of 60 dB. However, as already mentioned above, in particular an additional dynamic transmission power adaptation is required along with a static transmission power in a transmission system with severely fluctuating transmission characteristics. A fixed range is therefore conventionally predefined in a ramped manner with the permanently set output amplification of the D/A converter, and the transmission power range adaptation is carried out with a downstream device, for example a stage attenuator, over a predefined number of stages or steps, wherein, in mobile radio systems, a stage or step of this type normally comprises attenuation or, if necessary, amplification of 2 dB.

Here, it is particularly disadvantageous that dynamic transmission power adaptation requires additional space within a corresponding circuit arrangement. Furthermore, the implementation is extremely costly, since analog and digital devices are interconnected within one component, for example a stage attenuator. In addition, the required synchronization between the D/A converter and the stage attenuator represents a critical factor for range changeover within the guard period, particularly since the physical transmission path must be taken into consideration for the digital control signal of the stage attenuator, and also the conversion in steps of 2 dB. Finally, an initially very substantial amplification of the transmission signal by the D/A converter and subsequent, possibly substantial, attenuation of the transmission signal, if the output power is to be low, result in noise problems due to severe wideband noise, which may interfere with the receiver and consequently impose additional substantial requirements on filters arranged at the receiving end.

If, on the other hand, a range changeover of the transmission power takes place directly with the conversion from the digital to the analog signal, this normally also results in changes to the relative carrier signal-to-noise ratio. However, a ratio of this type is specified in dBc, i.e. in relation to the carrier, in essentially all specifications and standards for transmission systems.

An object of the invention is therefore to indicate a way of avoiding the highlighted problems of the state of the art, thereby ensuring an overall simpler and improved, in particular dynamic adaptation of transmission power levels in transmission systems with digitally processed transmission signals.

The achievement of the object is already characterized in a highly surprising manner by a method and a device with the features of Claim 1 and Claim 2.

Advantageous and/or preferred developments form the subject matter of the relevant dependent claims.

It is therefore provided according to the invention, in transmission systems in which a digitally processed transmission signal is converted for transmission into an analog signal, for the control of the transmission power range to be carried out through the provision of a D/A converter with an output amplifier having a controllably adjustable amplification. It is particularly advantageous here that, if the transmission signal is amplified only to the extent required for the respective transmission path, including associated path losses, in particular in radio-frequency transmission devices, an essentially more noise-free signal is emitted than in transmission devices according to the state of the art. This in turn imposes substantially lower requirements on the required filter arrangements. Furthermore, no additional, separate device is required for dynamic adaptation of the transmission power range, resulting in particular in space and material savings and consequently in a cost reduction in the production of corresponding transmission devices.

It is appropriately provided for the transmission signal to be tappable in floating-point format at the output of a device provided for digital signal processing, so that the fixed-point part is fed as a parameter to be converted of the core circuit of the D/A converter and the characteristic or exponent is used as a control signal for the amplification of the output amplifier of the D/A converter. Advantageously, only absolute, also referred to as spurious, changes occur in both the carrier signal and the interference. In other words, no changes are made in relation to defined or required carrier signal-to-noise ratios, so that essentially all the relevant specification regulations are satisfied. In addition, the requirements in terms of the accuracy of the design of an amplification which is directly related to the exponent of a floating-point format are substantially lower, since the fine graduation is carried out using the fixed-point part by means of the actual D/A conversion circuit, while a relatively only rough range adaptation of the power level is carried out via - the amplification. In addition, a further advantage is that, due to the direct connection of the D/A converter with adjustable output amplification to the digital signal processing, a conventionally used converter, which hitherto converted a floating-point format into a linear numerical presentation, including a digital stage control in each case of 2 dB, is no longer required, resulting overall in a further simplified, space-saving and, in terms of manufacture, lower-cost implementation of transmission power control devices.

In practice, it is furthermore proposed to carry out the method according to the invention expediently on the basis of a dual or binary code with reference to the digital signal processing, so that the controllably adjustable output amplification can be adjusted in 6-decibel steps. Even with an exponent comprising 3 bits, this produces a resulting virtual 7-bit increase in effective resolution and consequently a substantially more controllable dynamic range than that of the state of the art, at essentially no additional expense.

In addition, the isolation of digital and analog devices and the parallel control of the components directly via the fixed-point part and the exponent of a digitized signal represented in floating-point format results in a substantial simplification in terms of the synchronizations required for range changeovers which are to be carried out.

The invention will now be described in detail with reference to an exemplary embodiment and the attached drawings, in which:
- Fig. 1: shows a schematically substantially simplified part view of an embodiment according to the invention, and
- Fig. 2: shows a schematically substantially simplified corresponding part view of an embodiment according to the state of the art.

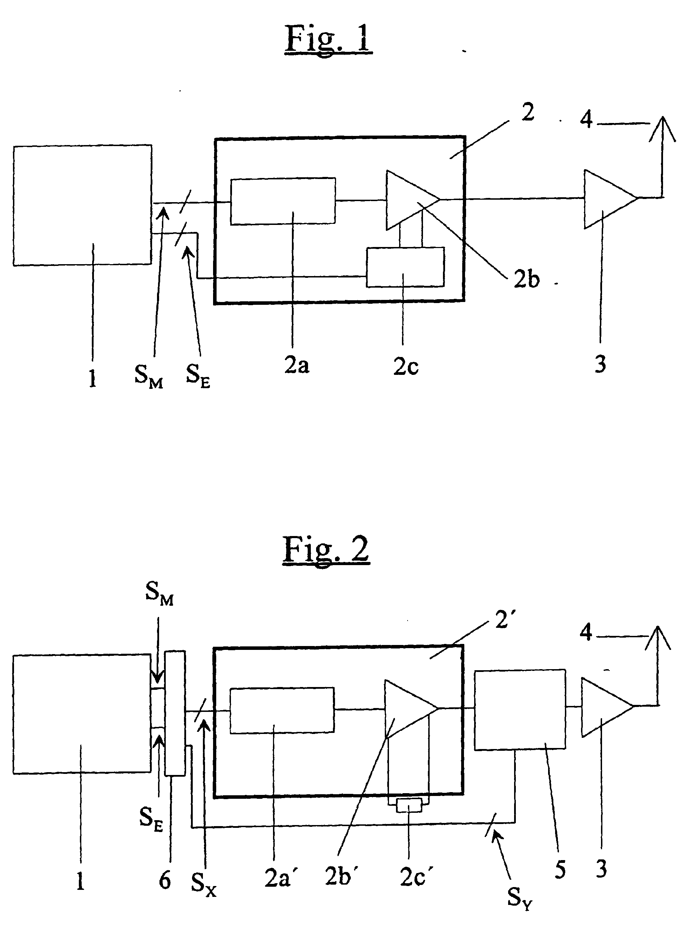

Reference is initially made below to Fig. 1, which, in simplified form, illustrates power adaptation according to the invention, based on the example of a mobile radio system, in particular the GSM standard.

Generally, the invention relates, within the signal-processing circuit of a transmission system, essentially to the subdomain in which a previously digitized signal has been digitally further processed and/or conditioned using a microprocessor, a digital signal processor or a different digital circuit 1 for information transmission, wherein the specific type and/or scope of the digital processing may differ substantially or is dependent on the relevant transmission system.

A specifically processed digital transmission signal S_{M} and S_{E}, for example, according to Fig. 1, present at the output of a digital signal processor 1 is fed to a downstream D/A converter 2, which in turn generates an analog transmission signal from the digital transmission signal. A downstream power amplifier 3 increases the power of the transmission signal to the transmission power correspondingly finally required by the transmission system and finally feeds the signal to a transmission antenna 4, which in turn converts the signal into a physical quantity. The power amplifier 3 and the transmission antenna 4 together form a typical transmission stage.

In transmission systems in which the individual transmission path parameters are not constant, frequent transmission signal power adaptation is often required in order to guarantee essentially constant signal power at the receiving end. Different or changing transmission path parameters may occur particularly as a result of the respective distance between the transmitter and the receiver, and the type of transmission medium. Consequently, in particular in mobile radio systems in which the distances between base stations and the respective mobile stations communicating with them can essentially change at any time and, in addition, the parameters of the radio transmission path are constantly subject to fluctuations due to geographical characteristics, demanding requirements are imposed on the continuous range adaptation of the transmission power which is required as a result.

For this purpose, it is provided according to the invention, as shown in Fig. 1, for the transmission signal present at the output of the digital transmitter signal processing device 1 to be provided in floating-point format over a fixed-point part S_{M} and a characteristic or exponent S_{E}. The transmission signal provided in this way is, as described below, used directly without further conversion to control the transmission power range.

The fixed-point part S_{M} of the digital transmission signal provided for practical purposes in dual code is fed to the core circuit 2a of the D/A converter 2. Furthermore, an adjustable amplification 2c, in the present exemplary embodiment in the form of a variable control resistance which is directly controlled via the exponent S_{E} of the digital transmission signal provided in floating-point format, is used for the output amplifier 2b according to the invention which is integrated in the D/A converter.

The core conversion circuit 2a and the output amplifier 2b of the D/A converter 2 are then directly controlled in parallel and completely synchronously in relation to one another by the signal S_{M}, S_{E} provided by the digital signal processor 1 in floating-point format.

In contrast to this, power range adaptation according to the state of the art conventionally provides range adaptation which comprises at least two stages, as shown in Fig. 2.

Thus, a D/A converter 2' of the type hitherto used comprises an integrated output amplifier 2b' which has a fixed amplification via a permanently prescribed resistance 2c', so that a fixed transmission power range is thus prescribed. Conventionally, a high amplification is initially set via the resistance 2c', dynamic level adaptation then taking place via a downstream stage attenuator 5, so that the power range can be controlled, in a manner known per se to the person skilled in the art, via predefinable power stages of normally 2 dB, according to the transmission path parameters.

The signal S_{X} fed to the core circuit 2a' of the D/A converter 2' conventionally occurs in linear, binary format, for example comprising 10 bits. However, given that, particularly in complex digital signal processing, floating-point arithmetic is essentially used, a transmitter signal S_{M} and S_{E} provided in floating-point format is therefore normally initially present at the output of the digital signal processor 1. Consequently, an additional converter 6 is furthermore required according to the state of the art, since the signal in floating-point format must initially be converted for further use, i.e. essentially into a digital signal S_{X} with a linear numerical representation and a control signal S_{Y}, with which the attenuation of the stage attenuator 5 can be set in stages in each case of 2 dB.

The preceding comparison therefore shows that, by avoiding an initially fixed output amplification of the D/A converter and a downstream staged attenuation and/or amplification of the resulting analog signal as a result of the output amplifier 2b of the D/A converter 2 according to the invention, which can already be adjusted in stages, a more noise-free signal is emitted in radio-frequency applications. As a result of thereby substantially reduced wideband noise, less demanding requirements can therefore also be imposed on further required filters.

Furthermore, in the embodiment according to the invention shown in Fig. 1, as a result of the control via the exponent S_{E}, the selectable power range is passed through in binary format in stages of 6 dB in each case. However, the fixed-point part S_{M} of the transmission signal determines the accuracy, so that the fine graduation is therefore carried out via the core 2a of the D/A converter 2 and the requirements - for the accuracy of the output amplifier 2b controlled via the exponent S_{E} are not very demanding. Amplification 2c of this type which can be controlled using the exponent S_{E} merely indicates how many places to the left the fixed-point part S_{M} must be shifted, i.e. it equates to an exponentiation.

Assuming that the exponent S_{E} comprises 3 bits, with which consequently 7 power range stages can be set, this therefore equates to a resulting shift of the fixed-point part S_{M} comprising, for example, 10 bits, by 7 positions to the left, to 17 bits, which in turn results in a substantially extended dynamic range of the power level adaptation.

Thus, a substantially extended dynamic range can be implemented with a device according to the invention, depending on the specific application, without having to implement an ultimately comparable, but highly elaborate and therefore high-cost control of the D/A converter according to the state of the art.

It is furthermore of practical significance that only a virtually improved resolution is involved according to the invention. In other words, with the amplification using the exponent, only an absolute change in the power levels occurs, so that the relative intervals between the individual transmissions remain equal in relation to one another. The method according to the invention is therefore suitable for all transmission systems with a defined carrier signal-to-noise ratio.

In addition, digital and analog signals or components are more substantially isolated by the method according to the invention compared with the state of the art, so that a substantially simpler synchronization can be ensured, particularly during changeover processes during the individual guard periods, in transmission systems using a time-slot method. Thus, for example due to the separate use of the fixed-point part and the exponent, the synchronization of the core conversion circuit 2a and the power range control 2b, 2_{G} already takes place within the signal processor 1. However, it must be noted that the changeover of the exponent should appropriately take place in the pause between the keying down and renewed keying up of the transmission power, but not necessarily the guard period, although this is appropriate, in particular to avoid interfering noise, for example "crackle".

## Claims

1. Method for controlling the transmission power level in transmission systems, in particular in mobile radio systems, in which a digitally processed transmission signal (S_{M}, S_{E}) is converted for transmission into an analog signal and is fed to a transmission stage (3, 4), **characterized in that** the digital transmission signal (S_{M}, S_{E}) is provided in floating-point format for conversion to an analog signal, the characteristic (S_{E}) being used to control the output amplification (2b, 2c).

2. Device for controlling the transmission power level in transmission systems, in particular in mobile radio systems, with a signal-processing circuit, comprising a processor (1) for digital processing of a transmission signal (S_{M}, S_{E}), a D/A converter (2) and an antenna (4), **characterized in that** the D/A converter (2) comprises an adjustable amplification means (2c) for controlling the transmission power level, in which the digital transmission signal (S_{M}, S_{E}) is provided in floating-point format for conversion to an analog signal, the characteristic (S_{E}) being used to control the output amplication means (2b, 2c).

3. Device according to Claim 2, **characterized in that** the processing device (1) for generating a digital transmission signal (S_{M}, S_{E}) is designed in floating-point format.

4. Device according to Claim 2 or 3, **characterized in that** the transmission signal (S_{M}, S_{E}) is present in binary code at the input of the D/A converter (2).

## Revendications

1. Procédé de commande du niveau de puissance d'émission dans des systèmes de transmission, en particulier les systèmes radio mobiles, dans lequel un signal de transmission traité numériquement (S_{M}, S_{E}) est converti pour sa transmission en un signal analogique et est passé à un étage de transmission (3, 4), **caractérisé en ce que** le signal de transmission numérique (S_{M}, S_{E}) est fourni dans un format à virgule flottante pour sa conversion en un signal analogique, la caractéristique (S_{E}) servant à commander l'amplification de sortie (2b, 2c).

2. Dispositif de commande du niveau de puissance d'émission dans ses systèmes de transmission, en particulier les systèmes radio mobiles, avec un circuit de traitement de signaux, comprenant un processeur (1) pour le traitement numérique d'un signal de transmission (S_{M}, S_{E}), un convertisseur N/A (2) et une antenne (4), **caractérisé en ce que** le convertisseur N/A (2) comprend un moyen d'amplification réglable (2c) pour commander le niveau de puissance de transmission, dans lequel le signal de transmission numérique (S_{M}, S_{E}) est fourni dans un format à virgule flottante pour sa conversion en un signal analogique, la caractéristique (S_{E}) servant à commander le moyen d'amplification de sortie (2b, 2c).

3. Dispositif selon la revendication 2, **caractérisé en ce que** le dispositif de traitement (1) pour générer un signal de transmission numérique (S_{M}, S_{E}) est conçu dans le format à virgule flottante.

4. Dispositif selon la revendication 2 ou 3, **caractérisé en ce que** le signal de transmission (S_{M}, S_{E}) est présent en code binaire à l'entrée du convertisseur N/A (2).

## Patentansprüche

1. Verfahren zur Steuerung des Sendeleistungspegels in Übertragungssystemen, insbesondere Mobilfunksystemen, bei dem ein digital verarbeitetes Übertragungssignal (S_{M}, S_{E}) zur Übertragung in ein Analogsignal umgesetzt und einer Übertragungsstufe (3, 4) zugeführt wird, **dadurch gekennzeichnet, daß** das digitale Übertragungssignal (S_{M}, S_{E}) zur Umsetzung in ein Analogsignal im Gleitkommaformat bereitgestellt wird, wobei die Charakteristik (S_{E}) zur Steuerung der Ausgangsverstärkung (2b, 2c) benutzt wird.

2. Einrichtung zur Steuerung des Sendeleistungspegels in Übertragungssystemen, insbesondere Mobilfunksystemen, mit einer Signalverarbeitungsschaltung, umfassend: einen Prozessor (1) zur digitalen Verarbeitung eines Übertragungssignals (S_{M}, S_{E}), einen D/A-Umsetzer (2) und eine Antenne (4), **dadurch gekennzeichnet, daß** der D/A-Umsetzer (2) einstellbare Verstärkungsmittel (2c) zur Steuerung des Sendeleistungspegels umfaßt, wobei das digitale Übertragungssignal (S_{M}, S_{E}) zur Umsetzung in ein Analogsignal im Gleitkommaformat bereitgestellt wird, wobei die Charakteristik (S_{E}) zur Steuerung der Ausgangsverstärkungsmittel (2b, 2c) benutzt wird.

3. Einrichtung nach Anspruch 2, **dadurch gekennzeichnet, daß** die Verarbeitungseinrichtung (1) zur Erzeugung eines digitalen Übertragungssignals (S_{M}, S_{E}) im Gleitkommaformat entworfen ist.

4. Einrichtung nach Anspruch 2 oder 3, **dadurch gekennzeichnet, daß** das Übertragungssignal (S_{M}, S_{E}) am Eingang des D/A-Umsetzers (2) in Binärcode vorliegt.
